# EUROPEAN PATENT APPLICATION

(11) **EP 4 411 816 A1**
(43) Date of publication of application: **07.08.2024**
(21) Application number: 23869280.0
(22) Date of filing: 26.09.2023
(51) Int. Cl.: H01L 25/07, H01L 23/48, H01L 23/31

(54) **ELECTRONIC PACKAGE, ELECTRONIC PACKAGING METHOD, METHOD FOR POWER SUPPLY IN ELECTRONIC PACKAGE, AND CHIP**

(30) Priority: 21.12.2022 CN 202211649309
(71) Applicant: Hygon Information Technology Co., Ltd., Tianjin 300392 (CN)
(72) Inventor: DU, Shuan, Tianjin 300392 (CN); MENG, Fanxiao, Tianjin 300392 (CN); YANG, Xiaojun, Tianjin 300392 (CN); YANG, Guanglin, Tianjin 300392 (CN); YU, Qin, Tianjin 300392 (CN)
(74) Representative: Maiwald GmbH
(86) International application number: PCT/CN2023/121547
(87) International publication number: WO 2024/131188

(57) **Abstract**

Embodiments of the disclosure provide an electronic packaging, an electronic packaging method, a supply power method in the electronic packaging, a chip, and an electronic device. The electronic packaging includes a packaging substrate, a transferring substrate and at least two dies. The packaging substrate includes a cavity, the cavity exposes a first surface of the packaging substrate, the transferring substrate is arranged in the cavity and is connected with the first surface; a first portion of the at least two dies is connected with the packaging substrate, and a second portion of the at least two dies is connected with the transferring substrate; the packaging substrate includes a first power supply layer; the second portion of the at least two dies is electrically connected with the first power supply layer through the transferring substrate, so that the first power supply layer supplies power to an electrical component in the second portion of the at least two dies. The technical solution of the disclosure is applied in a case of chip electric packaging.

## Description

The present application claims the priority of the Chinese patent application No. 202211649309.4 filed on December 21, 2022, and the content disclosed in the above Chinese patent application is cited in its entirety as a part of the present application.

### TECHNICAL FIELD

Embodiments of the present disclosure relate to an electronic packaging, an electronic packaging method, a supply power method in an electronic packaging, a chip, and an electronic device.

### BACKGROUND

In a high-performance chip architecture, considering factors such as cost and scalability etc., a chiplet architecture is widely used. A frequency of communication signals between different dies in a multi-chip module is getting higher and higher, and a requirement for the quality of power supply is increasing accordingly.

Usually, the power is supplied to each die through a power supply terminal of a main substrate, and then the power is supplied to different functional units inside the die through a power mesh inside the die. For some electrical components in the die, this supply power method has a problem that a supply power connection line is too long and parasitic inductance is large, resulting in large simultaneous switch noise (SSN), which seriously reduces a quality of the power supply for supply power to some electrical components in the die.

### SUMMARY

In view of this, embodiments of the present disclosure provide an electronic packaging, an electronic packaging method, a supply power method in an electronic packaging and a chip, which can improve the quality of the power supply for supply power to some electrical components in the die.

In a first aspect, embodiments of the disclosure provide an electronic packaging, including a packaging substrate, a transferring substrate and at least two dies. The packaging substrate includes a cavity, the cavity exposes a first surface of the packaging substrate, the transferring substrate is arranged in the cavity and is connected with the first surface; a first portion of the at least two dies is connected with the packaging substrate, and a second portion of the at least two dies is connected with the transferring substrate; the packaging substrate includes a first power supply layer; the second portion of the at least two dies is electrically connected with the first power supply layer through the transferring substrate, so that the first power supply layer supplies power to an electrical component in the second portion of the at least two dies.

Optionally, the at least two dies include a first die and a second die; the packaging substrate includes a first interposer layer, and the first interposer layer includes the first power supply layer; the first power supply layer is located below the cavity; the packaging substrate includes a first metal via, a first end of the first metal via is electrically connected with the first power supply layer, and a second end of the first metal via is exposed to the bottom of the cavity; the transferring substrate includes a second interposer layer, the second interposer layer includes a second metal via, a first end of the second metal via is electrically connected with the second end of the first metal via, a second end of the second metal via is electrically connected with a second portion of the first die and/or a second portion of the second die.

Optionally, the first end of the second metal via is electrically connected with the second end of the first metal via through a connection bump; or the transferring substrate further includes a second power supply layer, and the second interposer layer is arranged on the second power supply layer; the second end of the first metal via is electrically connected with a first surface of the second power supply layer, and the first end of the second metal via is electrically connected with a second surface of the second power supply layer; a number of each of the first metal vias and the second metal vias is more than two; more than two first metal vias and more than two second metal vias are respectively arranged side by side.

Optionally, the transferring substrate further includes a supporting layer; the second interposer layer is located on the supporting layer; the supporting layer includes a third metal via, and a first end of the third metal via is electrically connected with the second end of the first metal via; a second end of the third metal via is electrically connected with the first end of the second metal via; or the transferring substrate further includes a second power supply layer, the second power supply layer is located on the supporting layer; the second interposer layer is located on the second power supply layer; the supporting layer includes a third metal via, a first end of the third metal via is electrically connected with the second end of the first metal via, and a second end of the third metal via is electrically connected with the first surface of the second power supply layer; the first end of the second metal via is electrically connected with the second surface of the second power supply layer; a number of each of the first metal vias, the second metal vias and the third metal vias is more than two; more than two first metal vias, more than two second metal vias and more than two third metal vias are respectively arranged side by side.

Optionally, the packaging substrate further comprises a power supply reference ground layer; the second portion of the at least two dies is further connected with the power supply reference ground layer through the transferring substrate.

In a second aspect, embodiments of the disclosure provides an electronic packaging method, including: manufacturing a packaging substrate, wherein the packaging substrate includes a cavity, a first metal via and a first power supply layer; the cavity exposes a first surface of the packaging substrate, and the first power supply layer is located below the cavity; a first end of the first metal via is electrically connected with the first power supply layer, and a second end of the first metal via is exposed to the first surface; manufacturing a transferring substrate, wherein the transferring substrate includes a second metal via; arranging the transferring substrate in the cavity, and making a bottom of the transferring substrate to be electrically connected with the first power supply layer through the first metal via of the packaging substrate; connecting a first portion of the at least two dies with the packaging substrate, connecting a second portion of the at least two dies with the transferring substrate, and making a component in the second portion of the at least two dies to be electrically connected with the first metal via of the packaging substrate through the second metal via of the transferring substrate, so that the first power supply layer supplies power to the component in the second portion of the at least two dies.

Optionally, the manufacturing the packaging substrate includes: forming a first interposer layer on the substrate, the first interposer layer including the first power supply layer; forming the cavity with an opening on an upper surface of the first interposer layer; forming the first metal via at the bottom of the cavity so that a first end of the first metal via is electrically connected with the first power supply layer; forming a first connection bump at the second end of the first metal via.

Optionally, the manufacturing the transferring substrate includes: forming a third metal via in a supporting layer; forming an interposer layer on a first surface of the supporting layer; the interposer layer including the second metal via, and the second metal via being electrically connected with the third metal via; thinning a second surface of the supporting layer to expose a first end of the third metal via; forming a second connection bump at the first end of the third metal via.

Optionally, the arranging the transferring substrate in the cavity, and making the bottom of the transferring substrate to be electrically connected with the first power supply layer through the first metal via of the packaging substrate, includes: arranging the transferring substrate in the cavity, and making the second connection bump to be electrically connected with the first connection bump correspondingly.

In a third aspect, embodiments of the disclosure provide a supply power method in an electronic packaging, including: providing a power supply to a first power supply layer in a packaging substrate; transmitting a power supply voltage from the first power supply layer to a transferring substrate through the packaging substrate; transmitting the power supply voltage to an electrical component in a second portion of at least two dies through the transferring substrate. A first portion of the at least two die is electrically connected with the packaging substrate, and the second portion of the at least two die is electrically connected with the transferring substrate.

Optionally, the transmitting a power supply voltage from the first power supply layer to the transferring substrate through the packaging substrate, includes: transmitting the power supply voltage from the first power supply layer to the transferring substrate through a first metal via of the packaging substrate that is electrically connected with the first power supply layer.

Optionally, the transmitting the power supply voltage to the electrical component in the second portion of at least two dies through the transferring substrate, includes: transmitting the power supply voltage to the electrical component in the second portion of at least two dies through a second metal via of the transferring substrate; the second metal via is electrically connected with the first metal via, and the second metal via is electrically connected with the second portion of the at least two dies.

Optionally, the transmitting the power supply voltage from the first power supply layer to the transferring substrate through the packaging substrate, includes: transmitting the power supply voltage from the first power supply layer to a second power supply layer of the transferring substrate through the packaging substrate;
the transmitting the power supply voltage to the electrical component in the second portion of at least two dies through the transferring substrate, includes: transmitting the power supply voltage to the electrical component in the second portion of the at least two dies through the second power supply layer of the transferring substrate

In a fourth aspect, embodiments of the disclosure further provide a chip, including a packaging. Any electronic packaging provided by embodiments of the disclosure is packaged in the packaging.

In a fifth aspect, embodiments of the disclosure further provide an electronic device, including a motherboard. Any chip provided by embodiments of the disclosure is installed on the motherboard.

### BRIEF DESCRIPTION OF DRAWINGS

In order to more clearly illustrate the technical solutions in the embodiments of the present disclosure, drawings required to be used in the embodiments will be briefly introduced below. Obviously, the drawings in the following description are only some embodiments of the present disclosure, those of ordinary skill in the art can further obtain other drawings based on these drawings without any creative efforts.
FIG. 1 is a schematic structural diagram of an electronic packaging provided by embodiments of the present disclosure;
FIG. 2 is a schematic structural diagram of a packaging substrate in embodiments of the present disclosure;
FIG. 3 is a schematic structural diagram of a transferring substrate in embodiments of the present disclosure;
FIG. 4 is a schematic flowchart of an electronic packaging method provided by embodiments of the present disclosure;
FIG. 5 and FIG. 6 are schematic diagrams of manufacturing a transferring substrate in embodiments of the present disclosure; and
FIG. 7 is a schematic flowchart of a supply power method in an electronic packaging provided by embodiments of the present disclosure.

### DETAILED DESCRIPTION

The embodiments of the present disclosure will be described in detail below with reference to the accompanying drawings.

It should be understood that the described embodiments are only some, but not all of the embodiments of the present disclosure. Based on the embodiments of the present disclosure, all other embodiments obtained by those of ordinary skill in the art without any creative efforts fall within the scope of protection of the present disclosure.

An embodiment of the present disclosure provides an electronic packaging, which includes a packaging substrate, a transferring substrate and at least two dies; the packaging substrate includes a cavity, the cavity exposes a first surface of the packaging substrate, the transferring substrate is arranged in the cavity and is connected with the first surface; a first portion of the at least two dies is connected with the packaging substrate, and a second portion of the at least two dies is connected with the transferring substrate; the packaging substrate includes a first power supply layer; the second portion of the at least two dies is electrically connected with the first power supply layer through the transferring substrate, so that the first power supply layer supplies power to an electrical component in the second portion of the at least two dies.

In this way, because the second portion of the die is directly located above the transferring substrate, a supply power connection line formed by the second portion of the die being connected with the first power supply layer in the packaging substrate through the transferring substrate is shorter. Compared with a supply power method of transmitting power supply voltage to the first portion of the die through the packaging substrate, and then transmitting the power supply voltage to the second portion of the die through a power mesh in the die, the embodiments of the present disclosure can greatly shorten a length of the supply power connection line, thereby reducing parasitic inductance of the supply power connection line, to further reduce simultaneous switch noise, to improve quality of the power supply for supply power to the electrical component in the second portion of the die.

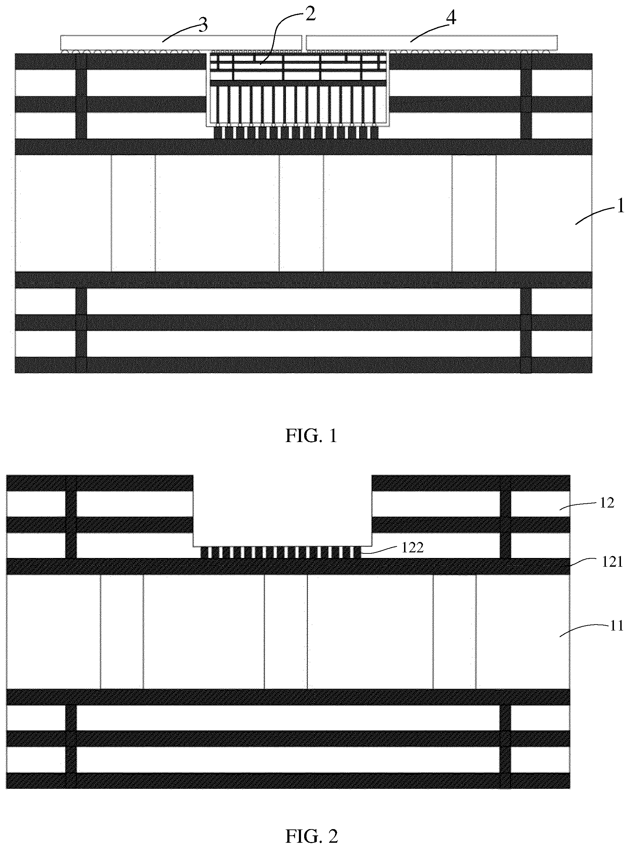

In the first aspect, as illustrated in FIG. 1, the first embodiment of the present disclosure provides an electronic packaging, which includes a packaging substrate 1, a transferring substrate 2 and at least two dies; the packaging substrate 1 includes a cavity, and the cavity exposes a first surface of the packaging substrate 1, and the transferring substrate 2 is arranged in the cavity and connected with the first surface; a first portion of the at least two dies is connected with the packaging substrate 1, and a second portion of the at least two dies is connected with the transferring substrate 2; the packaging substrate 1 includes a first power supply layer; the second portion of the at least two dies is electrically connected with the first power supply layer through the transferring substrate 2, so that the first power supply layer supplies power to an electrical component in the second portion of the at least two dies.

For example, as illustrated in FIG. 1, the at least two dies include a first die 3 and a second die 4; as illustrated in FIG. 2, the packaging substrate 1 includes a first interposer layer 12, and the first interposer layer 12 includes the first power supply layer 121; the first power supply layer 121 is located below the cavity; the packaging substrate 1 includes a first metal via 122, a first end of the first metal via 122 is electrically connected with the first power supply layer 121, and a second end of the first metal via 122 is exposed to the bottom of the cavity; the transferring substrate 2 includes a second interposer layer 21, the second interposer layer 21 includes a second metal via 211, and a first end of the second metal via 211 is electrically connected with the second end of the first metal via 122, and a second end of the second metal via 211 is electrically connected with a second portion of the first die 3 and/or a second portion of the second die 4.

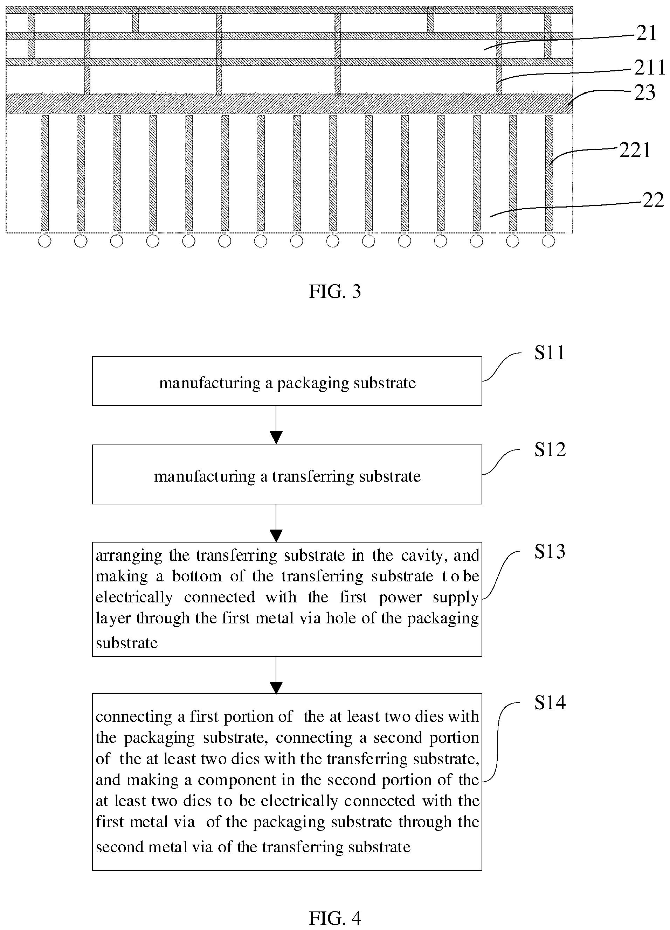

For example, as illustrated in FIG. 3, the transferring substrate 2 includes a second power supply layer 23, which is located on the supporting layer 22; the second interposer layer 21 is located on the second power supply layer 23; the supporting layer 22 includes a third metal via 221, a first end of the third metal via 221 is electrically connected with the second end of the first metal via 122, and a second end of the third metal via 221 is electrically connected with the first surface of the second power supply layer 23; the first end of the second metal via 211 is electrically connected with the second surface of the second power supply layer 23; a number of each of the first metal vias 122, the second metal vias 211 and the third metal vias 221 is two or more; the two or more first metal vias 122, the two or more second metal vias 211 and the two or more third metal vias 221 are respectively arranged side by side.

Specifically, as illustrated in FIG. 1, the electronic packaging provided by the first embodiment of the present disclosure includes the packaging substrate 1, the transferring substrate 2 and at least two dies. The packaging substrate 1 serves as a main substrate and includes a cavity, and the cavity exposes the first surface of the packaging substrate 1. The transferring substrate 2 is connected with the first surface so as to be fixed in the packaging substrate 1, and it can further make an upper surface of the packaging substrate 1 be flush with an upper surface of the transferring substrate 2. The at least two dies may include a first die 3 and a second die 4, a first portion of the first die 3 and a first portion of the second die 4 may be welded to the upper surface of the packaging substrate 1 respectively, so that a signal in the die is guided through the packaging substrate 1. A second portion of the first die 3 and a second portion of the second die 4 may be welded to the upper surface of the transferring substrate 2 respectively. In this way, the second portion of the first die 3 and the second portion of the second die 4 can perform signal interaction through high-density interconnection lines on the transferring substrate 2, and a typical width of the high-density interconnection lines is 2 microns.

As illustrated in FIG. 2, the packaging substrate 1 may include a base substrate 11 having a function of supporting, a first interposer layer 12 (for example, a stacking layer) may further be formed on the base substrate 11, the first interposer layer 12 may include a first power supply layer 121, the first power supply layer 121 may be specifically a metal layer electrically connected with an external power supply for supply power, and the first power supply layer 121 may be located below the cavity in the interposer layer 12.

On a bottom surface of the cavity in the packaging substrate 1, a metal via (for example, the first metal via 122) connecting from the bottom surface of the cavity to the first power supply layer 121 can be manufactured by laser drilling and electroplating, that is, a lower end of the first metal via 122 (for example, the first end) can be connected with the first power supply layer 121, and an upper end (for example, the second end) of the first metal via 122 is exposed to the bottom (for example, the first surface) of the cavity, so that the first power supply layer 121 can be electrically connected with the bottom surface of the cavity. A typical value of a diameter size of the first metal via 122 is 70 microns, in a case where a number of the first metal vias 122 is multiple, a typical value of a center distance between two adjacent first metal vias 122 is 130 microns.

As illustrated in FIG. 3, the transferring substrate 2 may include a second interposer layer 21 and a supporting layer 22, and the supporting layer 22 may have a function of supporting the second interposer layer 21. For example, a material of the supporting layer 22 can be silicon or glass, and a material of the second interposer layer 21 can be soft polyimide.

On the second interposer layer 21, a second metal via 211 connecting from the upper surface of the transferring substrate 2 to a lower surface of the transferring substrate 2 can be manufactured by etching and electroplating. In the same manner, a third metal via 221 connecting from an upper surface of the supporting layer 22 to a lower surface of the supporting layer 22 can further be manufactured in the supporting layer 22, that is, an upper end of the third metal via 221 is exposed to the upper surface of the supporting layer 22, and a lower end of the third metal via 221 is exposed to the lower surface of the supporting layer 22. A second power supply layer 23 may further be formed on the upper surface of the supporting layer 22 by etching and electroplating, and the second interposer layer 21 is formed on an upper surface of the second power supply layer 23. A typical value of a diameter size of each of the second metal via 211 and the third metal via 221 is 10 microns, and a typical value of a length size of the third metal via 221 is 50 microns. In a case where a number of the third metal via 221 is multiple, a typical value of a center distance between two adjacent third metal vias 221 is 130 microns.

As illustrated in FIG. 1, the second portion of the first die 3 and the second portion of the second die 4 may be electrically connected with an upper end (for example, the second end) of the second metal via 211, and a lower end of the second metal via 211 may be electrically connected with the upper surface (for example, the second surface) of the second power supply layer 23. A lower surface (for example, the first surface) of the second power supply layer 23 may be electrically connected with the upper end of the third metal via 221, and the lower end of the third metal via 221 may be electrically connected with the upper end of the first metal via 122, the lower end of the metal via 122 is electrically connected with the first power supply layer 121. Based on the above connection relationship, the following can be achieved: the second portion of the first die 3 and the second portion of the second die 4 can be electrically connected with the first power supply layer 121 respectively, so that the first power supply layer 121 can supply power to the electrical component in each of the second portion of the first die 3 and the second portion of the second die 4 respectively through a supply power connection line at a power supply side (referred to as supply power connection line) formed by the above connection relationship.

A total length of the above supply power connection line is a sum of a length of the first metal via 122, a length of the third metal via 221, a thickness of the second power supply layer 23, a length of the second metal via 211 and a length of an internal supply power connection line in the second portion of the first die 3 (or the second die 4). Because the length of the internal supply power connection line in the second portion of the first die 3 (or the second die 4) is specifically a distance from a position where the first die 3 (or the second die 4) is electrically connected with the second metal via 211 to the electrical component in the second portion of the first die 3 (or the second die 4), the distance is very small, and the length of the first metal via 122, the length of the third metal via 221, the thickness of the second power supply layer 23, the length of the second metal via 211 are also very small. In one example, the total length of the above supply power connection line may be 0.1mm.

A total length of the supply power connection line of the second portion of the first die 3 (or the second die 4) is, a sum of a length of an external supply power connection line through which the first power layer 121 transmits the power supply voltage through the packaging substrate 1 to the first portion of the first die 3 (or the second die 4) and a length of an internal supply power connection line in the first die 3 (or the second die 4) transferring the power supply voltage from the first portion of the first die 3 (or the second die 4) to the second portion of the first die 3 (or the second die 4) through a power mesh. A length or a width of the die is generally several millimeters to 20 millimeters, as a result, the length of the internal supply power connection line in the first die 3 (or the second die 4) is often as high as several millimeters to more than ten millimeters, which is much larger than the length of the supply power connection line inside the die in the first embodiment of the present disclosure.

Comparing both of them, the total length of the supply power connection line in the first embodiment of the present disclosure is much smaller than the total length of the above supply power connection line mentioned above. Therefore, the parasitic inductance of the supply power connection line can be reduced, thereby reducing simultaneous switch noise and improving the quality of the power supply for supply power to the electrical component in the second portion of the first die 3 (or the second die 4).

In the first embodiment of the present disclosure, by arranging the second power supply layer 23 (specifically, a copper-clad layer) between the second interposer layer 21 and the supporting layer 22, the resistance of the supply power connection line can be reduced, and thus loss of the supply power connection line can be reduced. In another example, the resistance of the supply power connection line can be further reduced by increasing the thickness of the second power supply layer 23, thereby further reducing the loss generated on the supply power connection line. A typical value of the thickness of the second power supply layer 23 can be 4 microns.

In another example of the first embodiment of the present disclosure, as illustrated in FIG. 2, a number of each of the first metal vias 122, the second metal vias 211 and the third metal vias 221 may be two or more, and each of the first metal vias 122, the second metal vias 211 and the third metal vias 221 can all be designed to be connected in parallel, thereby reducing the resistance of the supply power connection line, to reduce the loss generated on the supply power connection line, and at the same time reduce power supply noise.

The second embodiment of the present disclosure provides another electronic packaging. The same parts of the electronic packaging in the second embodiment as the electronic packaging provided by the first embodiment of the present disclosure will not be repeated here. Compared with the electronic packaging provided in the first embodiment, the difference of the electronic packaging in the second embodiment is in that the second embodiment of the present disclosure does not provide a second power supply layer 23 between a second interposer layer 21 and a supporting layer 22. Correspondingly, the lower end of the second metal via 211 can be electrically connected with the upper end of the third metal via 221, and at the same time, other connection relationships keep unchanged.

In this way, the first power supply layer 121 can transmit the power supply voltage to the second portion of the first die 3 (or the second die 4) through the first metal via 122, the third metal via 221 and the second metal via 211. The embodiments of the present disclosure can reduce the length of the supply power connection line, thereby reducing the parasitic inductance of the supply power connection line, reducing simultaneous switch noise, and improving the quality of the power supply for the electrical component in the second portion of the first die 3(or the second die 4).

In the second embodiment of the present disclosure, the number of each of the first metal via 122, the second metal via 211 and the third metal via 221 can be one, or can be more than two, provided that the electrical connection can be achieved. The second embodiment of the present disclosure does not limit to this.

The third embodiment of the present disclosure further provides another electronic packaging. The same parts of the electronic packaging in the third embodiment as the electronic packaging provided by the second embodiment of the present disclosure will not be repeated here. Compared with the electronic packaging provided in the second embodiment, the difference of the electronic packaging in the third embodiment is in that the second interposer layer 21 in the third embodiment can be made of silicon, which has high hardness, and thus the supporting layer 22 is not needed to be arranged. Correspondingly, the lower end of the second metal via 211 may be electrically connected with the upper end of the first metal via 122. In this way, the first power supply layer 121 can transmit the power supply voltage to the second portion of the first die 3 (or the second die 4) through the first metal via 122 and the second metal via 211, thereby reducing the length of the supply power connection line, reducing the parasitic inductance of the supply power connection line, reducing simultaneous switch noise, and improving the quality of the power supply for supply power to the electrical component in the second portion of the first die 3(or the second die 4).

The fourth embodiment of the present disclosure further provides another electronic packaging. The same parts of the electronic packaging in the fourth embodiment as the electronic packaging provided by the third embodiment of the present disclosure will not be repeated here. Compared with the electronic packaging provided in the third embodiment, the difference of the electronic packaging in the fourth embodiment is in that in this electronic packaging, a connection bump is provided at the lower end of the second metal via 211, and the upper end of the first metal via 122 is further provided with a connection bump. By welding the above two connection bumps together, the lower end of the second metal via 211 and the upper end of the first metal via 122 can be electrically connected.

The fifth embodiment of the present disclosure further provides another electronic packaging. The same parts of the electronic packaging in the fifth embodiment as the electronic packaging provided by the third embodiment of the present disclosure will not be repeated here. Compared with the electronic packaging provided in the third embodiment, the difference of the electronic packaging in the fifth embodiment is in that in this electronic packaging, the transferring substrate 2 may include a second power supply layer 23, and a second interposer layer 21 is arranged on an upper surface of the second power supply layer 23. Therefore, the upper end of the first metal via 122 can be electrically connected with a lower surface of the second power supply layer 23, and the upper surface of the second power supply layer 23 can be connected with the lower end of the second metal via 211, and the upper end of the second metal via 211 may be electrically connected with the second portion of the first die 3 (or the second die 4).

In this way, the first power supply layer 121 can transmit the power supply voltage to the second portion of the first die 3 (or the second die 4) through the first metal via 122, the second power supply layer 23 and the second metal via 211. The embodiments of the present disclosure can reduce the length of the supply power connection line, thereby reducing the parasitic inductance of the supply power connection line, reducing simultaneous switch noise, and improving the quality of the power supply for supply power to the electrical component in the second portion of the first die 3(or the second die 4). The functions of the second power supply layer 23 in the embodiment of the present disclosure is the same as the functions of the second power supply layer 23 in the previous embodiment, which will not be repeated here.

In the fifth embodiment of the present d

Optionally, in an embodiment of the present disclosure, the first metal via 122 may be a via hole filled with a metal material, and the metal material may be copper. In this way, when the transferring substrate 2 is welded to the bottom of the cavity, solder can be prevented from pouring into the first metal via 122, thereby avoiding affecting welding effect. At the same time, the metal material in the first metal via 122 further helps to reduce the resistance of the first metal via 122.

Optionally, in an embodiment of the present disclosure, the packaging substrate 1 may further include a power supply reference ground layer, and the power supply reference ground layer may be a metal layer connected with an external power supply reference ground. The power supply reference ground layer corresponds to the aforementioned first power supply layer, and both of them are respectively a negative electrode and a positive electrode of the power supply.

In the embodiment of the present disclosure, the second portion of the first die 3 (or the second die 4) may be connected with the power supply reference ground layer through the transferring substrate 2. In one example, the second portion of the first die 3 (or the second die 4) can be connected with the power supply reference ground layer through a fourth metal via of the transferring substrate 2 and a fifth metal via below the cavity in the packaging substrate 1, which can shorten a length of a supply power connection line at a reference ground side, to further shorten a length of the entire supply power connection line (supply power connection line at the power supply side and supply power connection line at the reference ground side), thereby further reducing the parasitic inductance of the entire supply power connection line, reducing simultaneous switch noise, and improving the quality of the power supply for supply power to the electrical component in the second portion of the first die 3(or the second die 4). In the embodiment of the present disclosure, the power supply reference ground layer and the first power supply layer may be different metal layers, or both of them also may be parts separated from each other formed by dividing the same metal layer.

In the second aspect, as illustrated in FIG. 4, the embodiments of the present disclosure provide an electronic packaging method, which may include:
S 11, manufacturing a packaging substrate 1; the packaging substrate 1 includes a cavity, a first metal via 122 and a first power supply layer 121; the cavity exposes a first surface of the packaging substrate, and the first power supply layer is located below the cavity; a first end of the first metal via is electrically connected with the first power supply layer, and a second end of the first metal via is exposed to the first surface;
As illustrated in FIG. 2, the packaging substrate 1 can be serves as a main substrate, on the packaging substrate 1, and the cavity can be manufactured by using laser or an etching method. The first power supply layer 121 may be a metal layer electrically connected with an external power supply for supply power, and the first power supply layer 121 may be located below the cavity.

By laser drilling and electroplating, a metal via (for example, the first metal via 122) connecting from the bottom surface of the cavity to the first power supply layer 121 can be manufactured. That is, a lower end (for example, the first end) of the first metal via 122 can be electrically connected with the first power supply layer 121, and an upper end (for example, the second end) of the first metal via 122 can be exposed to the bottom of the cavity, so that the first power supply layer 121 is electrically connected with the first surface (for example, the bottom surface of the cavity). A typical value of a diameter size of the first metal via 122 is 70 microns, and a typical value of the center distance between two adjacent first metal vias 122 is 130 microns.

S12, manufacturing a transferring substrate 2, the transferring substrate 2 includes a second metal via 211;
In a case where the transferring substrate 2 is manufactured, a second metal via 211 connecting from an upper surface of the transferring substrate 2 to a lower surface of the transferring substrate 2 can be manufactured by etching and electroplating method. A typical value of a diameter size of the second metal via 211 is 10 microns.
S13, arranging the transferring substrate 2 in the cavity, and making a bottom of the transferring substrate 2 to be electrically connected with the first power supply layer 121 through the first metal via 122 of the packaging substrate 1;
As illustrated in FIG. 1, the transferring substrate 2 is connected with the bottom of the above cavity of the packaging substrate 1 (for example, by welding), so as to be fixed in the packaging substrate 1, and at the same time, it can also make an upper surface of the packaging substrate 1 to be flush with the upper surface of the transferring substrate 2. The bottom of the transferring substrate 2 can be electrically connected with the first power supply layer 121 through the first metal via 122 of the packaging substrate 1.

S14, connecting a first portion of the at least two dies with the packaging substrate 1, connecting a second portion of the at least two dies with the transferring substrate 1, and making a component in the second portion of the at least two dies to be electrically connected with the first metal via 122 of the packaging substrate 1 through the second metal via 211 of the transferring substrate 2, so that the first power supply layer 121 supplies power to the component in the second portion of the at least two dies.

In this step, as illustrated in FIG. 1, the at least two dies may include a first die 3 and a second die 4, a first portion of the first die 3 and a first portion of the second die 4 may be welded to the upper surface of the packaging substrate 1 respectively, and a second portion of the first die 3 and a second portion of the second die 4 may be welded to the upper surface of the transferring substrate 2 respectively. In this way, the second portion of the first die 3 and the second portion of the second die 4 can perform signal interaction through high-density interconnection lines on the transferring substrate 2, and a typical width of the high-density interconnection lines is 2 microns.

The second metal via 211 of the transferring substrate 2 can be electrically connected with the first metal via 122 of the packaging substrate 1 by welding, so that the first power supply layer can supply power to the component in the second portion of the first die 3 (or the second die 4) through the first metal via 122 and the second metal via.

A total length of a supply power connection line at a power supply side (referred to as supply power connection line) formed based on the above connection relationship is a sum of a length of the first metal via 122, a length of the second metal via 211 and a length of an internal supply power connection line in the second portion of the first die 3 (or the second die 4). Because the length of the internal supply power connection line in the second portion of the first die 3 (or the second die 4) is specifically a distance from a position where the first die 3 (or the second die 4) is electrically connected with the second metal via 211 to the electrical component in the second portion of the first die 3 (or the second die 4), and the distance is very small.

A total length of the supply power connection line of the second portion of the first die 3 (or the second die 4) is, a sum of a length of an external supply power connection line where the first power layer 121 transmits the power supply voltage through the packaging substrate 1 to the first portion of the first die 3 (or the second die 4) and a length of an internal supply power connection line in the first die 3 (or the second die 4) transferring the power supply voltage from the first portion of the first die 3 (or the second die 4) to the second portion of the first die 3 (or the second die 4) through a power mesh. A length or a width of the die is generally several millimeters to 20 millimeters. In this way, the length of the internal supply power connection line in the first die 3 (or the second die 4) is often as high as several millimeters to more than ten millimeters, which is much larger than the length of the supply power connection line inside the die in the first embodiment of the present disclosure.

Comparing both of them, the total length of the supply power connection line in the first embodiment of the present disclosure is much smaller than the total length of the above supply power connection line mentioned above. Therefore, the parasitic inductance of the supply power connection line can be reduced, thereby reducing simultaneous switch noise and improving the quality of the power supply for supply power to the electrical component in the second portion of the first die 3 (or the second die 4).

Optionally, in an embodiment of the present disclosure, as illustrated in FIG. 1, the step of manufacturing the packaging substrate 1 (step S11) may include: forming a first interposer layer 12 on the substrate, the first interposer layer 12 including the first power supply layer; forming the cavity with an opening on an upper surface of the first interposer layer 12; forming the first metal via 122 at the bottom of the cavity to make a first end of the first metal via 122 to be electrically connected with the first power supply layer; and forming a first connection bump at the second end of the first metal via 122.

Specifically, in a case of manufacturing the packaging substrate 1, a first interposer layer 12 (for example, a stacking layer) can be formed on a substrate having a function of supporting, the first interposer layer 12 is composed of a dielectric layer and a metal layer in which one metal layer may be the first power supply layer. The cavity can be manufactured on an upper surface of the first interposer layer by laser or etching method. Then, the first metal via 122 is manufactured at the bottom of the cavity, and a first connection bump is generated at the upper end of the first metal via 122, so that the first connection bump can be used to electrically connect with the transferring substrate 2 in subsequent process.

Optionally, in an embodiment of the present disclosure, forming the first metal via 122 at the bottom of the cavity may specifically include: filling a via hole formed at the bottom of the cavity with a metal material.

In embodiments of the present disclosure, a metal material, such as copper, may be filled in the via hole formed at the bottom of the cavity. In this way, when the transferring substrate 2 is welded to the bottom of the cavity, solder can be prevented from pouring into the first metal via 122, thereby avoiding affecting welding effect. At the same time, the metal material in the first metal via 122 further helps to reduce the resistance of the first metal via 122.

Optionally, in an embodiment of the present disclosure, the manufacturing of the transferring substrate 2 (step S12) may include: forming a third metal via 221 in the supporting layer 22; forming an interposer layer on a first surface of the supporting layer 22; the interposer layer including the second metal via 211, and the second metal via 211 being electrically connected with the third metal via 221; thinning a second surface of the supporting layer 22 to expose a first end of the third metal via 221; and forming a second connection bump at the first end of the third metal via 221.

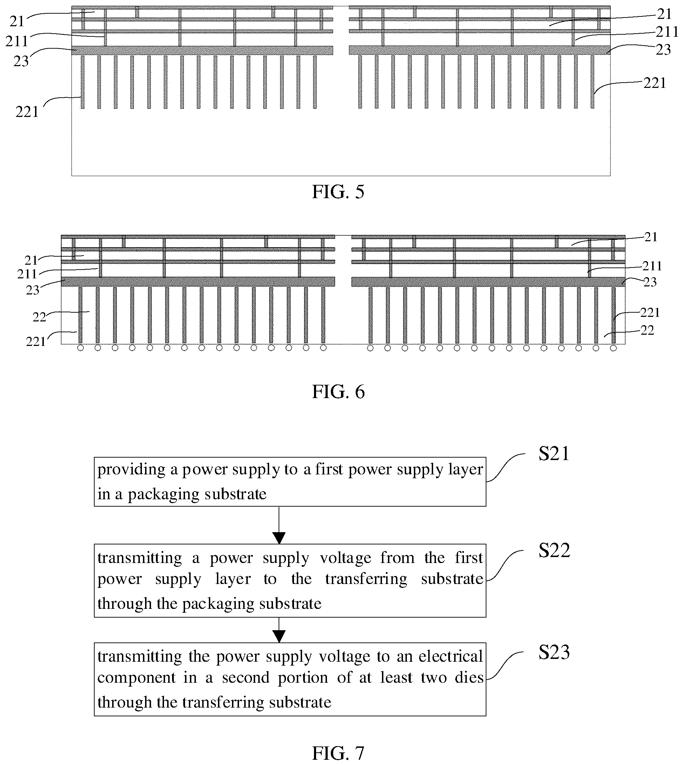

In the embodiment of the present disclosure, as illustrated in FIG. 5, in a case of manufacturing the transferring substrate 2, in order to facilitate processing, the third metal via 221 can be manufactured in a supporting layer 22 which has a larger area (which can be divided into multiple transferring substrates 2 in subsequent processes) and a thicker thickness (for example, the thickness is 700 microns). Then an interposer layer in which a dielectric layer overlaps with a metal layer can be formed on the upper surface of the supporting layer 22, and the metal layer includes a metal interconnection layer, so that the first die 3 can perform signal interaction with the second die 4 through the metal interconnection layer. Then a second metal via 211 electrically connected with the third metal via 221 can be manufactured in the interposer layer.

As illustrated in FIG. 6, finally, according to a target thickness of the supporting layer 22 (for example, the target thickness is 50 microns), a lower surface of the supporting layer 22 can be thinned by grinding, thereby reducing the thickness of the supporting layer 22 to 50 microns, during an actual implementation process, a lower end of the third metal via 221 may be exposed. Thereafter, a second connection bump may be formed at the lower end of the third metal via 221, and further the transferring substrate 2 is cut into a plurality of transferring substrates.

Optionally, in one embodiment of the present disclosure, the arranging the transferring substrate 2 in the cavity, and making the bottom of the transferring substrate 2 to be electrically connected with the first power supply layer through the first metal via 122 of the packaging substrate 1, including: arranging the transferring substrate 2 in the cavity, and making the second connection bump to be electrically connected with the first connection bump correspondingly.

In the embodiment of the present disclosure, after the transferring substrate 2 is arranged in the cavity, hot pressure bonding glue can be used to connect the first connection bump and the second connection bump together, so as to achieve an electrical connection between the first metal via 122 and the third metal via 221.

In the third aspect, as illustrated in FIG. 7, the embodiments of the present disclosure provide a supply power method in an electronic packaging, which may include:
S21, providing a power supply to a first power supply layer in a packaging substrate;
In this step, the packaging substrate includes a first power supply layer, the first power supply layer is a metal layer electrically connected with an external power supply. Therefore, the external power supply can provide a power supply voltage to the first power supply layer of the packaging substrate, and the first power supply layer is a positive electrode corresponding to the external power supply.

S22, transmitting the power supply voltage from the first power supply layer to the transferring substrate through the packaging substrate;
In this step, the first power supply layer can be electrically connected with the transferring substrate through the packaging substrate, so that the power supply voltage can be transmitted from the first power supply layer to the transferring substrate.

S23, transmitting the power supply voltage to an electrical component in a second portion of at least two dies through the transferring substrate; wherein a first portion of the at least two die is electrically connected with the packaging substrate, and the second portion of the at least two die is electrically connected with the transferring substrate.

In this step, the first portions of the at least two dies may be welded to an upper surface of the packaging substrate 1 respectively, so that a signal in the die is guided through the packaging substrate. The second portion of each of the at least two dies may be welded to an upper surface of the transferring substrate 2 respectively. Therefore, different dies of the at least two dies can interact signal with each other through the interconnection metal layer on the transferring substrate. A typical width of a metal line of the interconnection metal layer is 2 microns. Through the transferring substrate, the power supply voltage can be transmitted to the second portion of each die, thereby supplying power to the electrical component in the second portion.

In this way, because the second portion of the die is directly located above the transferring substrate, a supply power connection line formed by the second portion of the die being connected with the first power supply layer in the packaging substrate through the transferring substrate is shorter. Compared with a supply power method of transmitting the power supply voltage to the first portion of the die through the packaging substrate, and then transmitting the power supply voltage to the second portion of the die through a power mesh in the die, the embodiments of the present disclosure can greatly shorten a length of the supply power connection line, thereby reducing parasitic inductance of the supply power connection line, to further reduce simultaneous switch noise and improve quality of the power supply for supply power to the electrical component in the second portion of the die.

Optionally, in one embodiment of the present disclosure, the transmitting the power supply voltage from the first power supply layer to the transferring substrate through the packaging substrate (step S22), may include: transmitting the power supply voltage from the first power supply layer to the transferring substrate through a first metal via of the packaging substrate that is electrically connected with the first power supply layer.

In an embodiment of the present disclosure, on a bottom surface of the cavity in the packaging substrate 1, a metal via (for example, the first metal via) connecting from the bottom surface of the cavity to the first power supply layer can be manufactured by laser drilling and electroplating, so that the first power supply layer can be connected with the bottom surface of the cavity. After the transferring substrate is welded to the upper end of the first metal via on the bottom surface of the cavity, the transferring substrate can be electrically connected with the first power supply layer. Therefore, the power supply voltage can be transmitted from the first power supply layer to the transferring substrate through the first metal via of the packaging substrate.

Optionally, in an embodiment of the present disclosure, the transmitting the power supply voltage to the electrical component in the second portion of at least two dies through the transferring substrate, may include: transmitting the power supply voltage to the electrical component in the second portion of at least two dies through a second metal via of the transferring substrate; the second metal via is electrically connected with the first metal via, and the second metal via is electrically connected with the second portion of the at least two dies.

In an embodiment of the present disclosure, the second metal via connecting from the upper surface of the transferring substrate 2 to a lower surface of the transferring substrate 2 can be manufactured by etching and electroplating, an upper end of the second metal via can be connected with the second portion of the die, and a lower end of the second metal via can be electrically connected with the upper end of the first metal via. Therefore, the supply power voltage can be transmitted from the interposer substrate to the second portion of the die through the second metal via of the interposer substrate.

Optionally, in an embodiment of the present disclosure, the transmitting the power supply voltage from the first power supply layer to the transferring substrate through the packaging substrate (step S22), may include: transmitting the power supply voltage from the first power supply layer to a second power supply layer of the transferring substrate through the packaging substrate; the transmitting the power supply voltage to the electrical component in the second portion of at least two dies through the transferring substrate(step S23), may include: transmitting the power supply voltage to the electrical component in the second portion of the at least two dies through the second power supply layer of the transferring substrate.

In embodiments of the present disclosure, a second power supply layer may be arranged at the bottom of the transferring substrate, and the second power supply layer may be electrically connected with the first metal via of the packaging substrate and the second metal via of the transferring substrate at the same time. Therefore, the power supply voltage of the first power supply layer can be transmitted to the second power supply layer through the first metal via of the packaging substrate, and the power supply voltage can be further provided from the second power supply layer to the electrical component in the second portion of the die through the second metal via.

In the fifth aspect, the embodiments of the present disclosure further provides a chip, including a packaging. Any electronic packaging provided by the embodiments of the present disclosure is packaged in the packaging.

In the sixth aspect, the embodiments of the present disclosure further provide an electronic device, including a motherboard, and a chip is installed on the motherboard. The chip is any chip provided by the embodiments of the present disclosure.

Various embodiments of the present disclosure (embodiments of the electronic packaging, embodiments of the electronic packaging method, embodiments of the supply power method in the electronic packaging, embodiments of chip, and embodiments of the electronic device) are described in a relevant manner because they are basically similar to the method embodiments, please refer to the description of the method embodiments for relevant details.

It should be noted that, relational terms herein such as first and second are only used to distinguish one entity or operation from another entity or operation, and do not necessarily require or imply that these entities or operations are mutually exclusive, or any such actual relationship or sequence exists between them. Furthermore, the terms "comprise," "include," or any other variations thereof are intended to cover a non-exclusive inclusion such that a process, method, article, or device that includes a list of elements includes not only those elements, but also other elements not expressly listed, or elements inherent to the process, method, article, or device. Without further limitation, an element defined by the statement "comprises a..." does not exclude the presence of additional identical elements in a process, method, article, or device that includes the stated element.

Those of ordinary skill in the art can understand that all or part of the processes in the methods of the above embodiments can be implemented by instructing relevant hardware through a computer program, the program can be stored in a computer readable storage medium, and during execution, the program may include the processes of the embodiments of each of the above methods. The storage medium may be a magnetic disk, an optical disk, a read-only memory (Read-Only Memory, ROM) or a random access memory (Random Access Memory, RAM), etc.

The above are only specific embodiments of the present disclosure, but the protection scope of the present disclosure is not limited thereto. Any changes or replacements that can easily be imagined by any skilled person familiar with the technical field within the scope of this disclosure should be covered by the scope of protection scope of this disclosure. Therefore, the protection scope of the present disclosure should be based on the protection scope of the claims.

## Claims

1. An electronic packaging, comprising a packaging substrate, a transferring substrate and at least two dies, wherein
the packaging substrate comprises a cavity, the cavity exposes a first surface of the packaging substrate, the transferring substrate is arranged in the cavity and is connected with the first surface;
a first portion of the at least two dies is connected with the packaging substrate, and a second portion of the at least two dies is connected with the transferring substrate;
the packaging substrate comprises a first power supply layer; the second portion of the at least two dies is electrically connected with the first power supply layer through the transferring substrate, so that the first power supply layer supplies power to an electrical component in the second portion of the at least two dies.

2. The electronic packaging according to claim 1, wherein the at least two dies comprise a first die and a second die; the packaging substrate comprises a first interposer layer, and the first interposer layer comprises the first power supply layer; the first power supply layer is located below the cavity;
the packaging substrate comprises a first metal via, a first end of the first metal via is electrically connected with the first power supply layer, and a second end of the first metal via is exposed to the bottom of the cavity;
the transferring substrate comprises a second interposer layer, the second interposer layer comprises a second metal via, a first end of the second metal via is electrically connected with the second end of the first metal via, a second end of the second metal via is electrically connected with a second portion of the first die and/or a second portion of the second die.

3. The electronic packaging according to claim 2, wherein the first end of the second metal via is electrically connected with the second end of the first metal via through a connection bump; or,
the transferring substrate further comprises a second power supply layer, and the second interposer layer is arranged on the second power supply layer;
the second end of the first metal via is electrically connected with a first surface of the second power supply layer, and the first end of the second metal via is electrically connected with a second surface of the second power supply layer; wherein a number of each of the first metal vias and the second metal vias is more than two; more than two first metal vias and more than two second metal vias are respectively arranged side by side.

4. The electronic packaging according to claim 2, wherein the transferring substrate further comprises a supporting layer;
the second interposer layer is located on the supporting layer; the supporting layer comprises a third metal via, and a first end of the third metal via is electrically connected with the second end of the first metal via; a second end of the third metal via is electrically connected with the first end of the second metal via; or,
the transferring substrate further comprises a second power supply layer, the second power supply layer is located on the supporting layer; the second interposer layer is located on the second power supply layer; the supporting layer comprises a third metal via, a first end of the third metal via is electrically connected with the second end of the first metal via, and a second end of the third metal via is electrically connected with the first surface of the second power supply layer; the first end of the second metal via is electrically connected with the second surface of the second power supply layer; wherein a number of each of the first metal vias, the second metal vias and the third metal vias is more than two; more than two first metal vias, more than two second metal vias and more than two third metal vias are respectively arranged side by side.

5. The electronic packaging according to any one of claims 1 to 4, wherein the packaging substrate further comprises a power supply reference ground layer; the second portion of the at least two dies is further connected with the power supply reference ground layer through the transferring substrate.

6. An electronic packaging method, comprising:
manufacturing a packaging substrate, wherein the packaging substrate comprises a cavity, a first metal via and a first power supply layer; the cavity exposes a first surface of the packaging substrate, and the first power supply layer is located below the cavity; a first end of the first metal via is electrically connected with the first power supply layer, and a second end of the first metal via is exposed to the first surface;
manufacturing a transferring substrate, wherein the transferring substrate comprises a second metal via;
arranging the transferring substrate in the cavity, and making a bottom of the transferring substrate to be electrically connected with the first power supply layer through the first metal via of the packaging substrate;
connecting a first portion of the at least two dies with the packaging substrate, connecting a second portion of the at least two dies with the transferring substrate, and making a component in the second portion of the at least two dies to be electrically connected with the first metal via of the packaging substrate through the second metal via of the transferring substrate, so that the first power supply layer supplies power to the component in the second portion of the at least two dies.

7. The electronic packaging method according to claim 6, wherein the manufacturing the packaging substrate comprises:
forming a first interposer layer on the substrate, the first interposer layer comprising the first power supply layer;
forming the cavity with an opening on an upper surface of the first interposer layer;
forming the first metal via at the bottom of the cavity so that a first end of the first metal via is electrically connected with the first power supply layer;
forming a first connection bump at the second end of the first metal via.

8. The electronic packaging method according to claim 7, wherein the manufacturing the transferring substrate comprises:
forming a third metal via in a supporting layer;
forming an interposer layer on a first surface of the supporting layer; the interposer layer comprising the second metal via, and the second metal via being electrically connected with the third metal via;
thinning a second surface of the supporting layer to expose a first end of the third metal via;
forming a second connection bump at the first end of the third metal via.

9. The electronic packaging method according to claim 8, wherein the arranging the transferring substrate in the cavity, and making the bottom of the transferring substrate to be electrically connected with the first power supply layer through the first metal via of the packaging substrate, comprises:
arranging the transferring substrate in the cavity, and making the second connection bump to be electrically connected with the first connection bump correspondingly.

10. A supply power method in an electronic packaging, comprising:
providing a power supply to a first power supply layer in a packaging substrate;
transmitting a power supply voltage from the first power supply layer to a transferring substrate through the packaging substrate;
transmitting the power supply voltage to an electrical component in a second portion of at least two dies through the transferring substrate;
wherein a first portion of the at least two die is electrically connected with the packaging substrate, and the second portion of the at least two die is electrically connected with the transferring substrate.

11. The supply power method in the electronic packaging according to claim 10, wherein the transmitting a power supply voltage from the first power supply layer to the transferring substrate through the packaging substrate, comprises:
transmitting the power supply voltage from the first power supply layer to the transferring substrate through a first metal via of the packaging substrate that is electrically connected with the first power supply layer.

12. The supply power method in the electronic packaging according to claim 11, wherein the transmitting the power supply voltage to the electrical component in the second portion of at least two dies through the transferring substrate, comprises:
transmitting the power supply voltage to the electrical component in the second portion of at least two dies through a second metal via of the transferring substrate; wherein the second metal via is electrically connected with the first metal via, and the second metal via is electrically connected with the second portion of the at least two dies.

13. The supply power method in the electronic packaging according to claim 10, wherein
the transmitting the power supply voltage from the first power supply layer to the transferring substrate through the packaging substrate, comprises: transmitting the power supply voltage from the first power supply layer to a second power supply layer of the transferring substrate through the packaging substrate;
the transmitting the power supply voltage to the electrical component in the second portion of at least two dies through the transferring substrate, comprises: transmitting the power supply voltage to the electrical component in the second portion of the at least two dies through the second power supply layer of the transferring substrate.

14. A chip, comprising a packaging, wherein the electronic packaging according to any one of claims 1 to 5 is packaged in the packaging.

15. An electronic device, comprising a motherboard, wherein a chip is installed on the motherboard, and the chip is the chip according to claim 14.
